# EUROPEAN PATENT APPLICATION

(11) **EP 1 638 378 A1**
(43) Date of publication of application: **22.03.2006**
(21) Application number: 03733244.2
(22) Date of filing: 02.06.2003
(51) Int. Cl.: H05K 1/03, C08J 5/24, B32B 15/08

(54) **PREPREG FOR PRINTED WIRING BOARD AND COPPER-CLAD LAMINATED BOARD**

(71) Applicant: MATSUSHITA ELECTRIC WORKS, LTD., Kadoma-shi, Osaka 571-8686 (JP)
(72) Inventor: ITOU, Katsuhiko, Matsushita Electric Works, Ltd., Kadoma-shi, Osaka 571-8686 (JP); HIBINO, Akinori, Matsushita Electric Works, Ltd., Kadoma-shi, Osaka 571-8686 (JP); MOTOBE, Hidetsugu, Matsushita Electric Works, Ltd., Kadoma-shi, Osaka 571-8686 (JP)
(74) Representative: Falk, Urs
(86) International application number: PCT/JP2003/006964
(87) International publication number: WO 2004/110115

(57) **Abstract**

A prepreg for a printed wiring board **characterized** with use of a brominated epoxy resin, possessing a peak intensity of infrared absorption spectrum at 2100 to 2300 cm⁻¹, which is 5% or lower than that of a benzene ring carbon-carbon double bond at 1600 cm⁻¹ as measured with an infrared absorption spectrometer as well as having an inflection point between 120 and 150°C in the cured product of said brominated epoxy resin as measured by means of a differential scanning calorimeter. The prepreg for the printed wiring board is superior in hygroscopicity, heat resistance, and desmear capability as a printed wiring board material and can be used to manufacture a copper-clad laminate board.

## Description

### FIELD OF INVENTION

The present invention relates to a prepreg for a printed wiring board, having improved hygroscopicity, heat resistance and desmear capability, and to a copper-clad laminate board using this prepreg.

### BACKGROUND OF THE INVENTION

A prepreg, used in manufacturing of printed wiring boards, is prepared by impregnating a substrate such as a glass cloth with a varnish of a resin composition mainly composed of a thermosetting resin such as an epoxy resin, followed by drying it into a half-cured state (B-stage). At this stage, the above resin composition is converted from an uncured resin to a semi-cured one. After this prepreg is cut into a desired size, a required number of sheets of the prepreg are stacked. A metal foil, such as a copper foil, is then placed on one or both sides of the stacked prepreg, followed by hot-pressing them through laminate molding to yield a metal foil-clad laminate board, which is used in manufacturing of a printed wiring board. At this stage, the semi-cured resin is converted into a fully cured resin to form an insulation layer together with the substrate. Thereafter, a through hole is formed by drilling a hole through the insulation layer and metal-plating it, and an outer layer circuit is formed by applying a subtractive method to the metal foil in one or both sides of the insulation layer, so as to manufacture a printed wiring board.

In addition, after a prepreg prepared as described above is cut into a desired size, and a required number of sheets of the prepreg are stacked on either one or both sides of a substrate for an inner layer, in which a circuit pattern as an inner layer circuit has been formed beforehand, followed by placing a metal foil, such as copper foil, on one or both sides of the stacked prepreg and then hot-pressing them through laminate molding, to yield a multilayered wiring board, which is used in manufacturing of a multilayered printed wiring board. Similarly as above, the semi-cured resin in the prepreg is converted to the fully cured resin at this stage to form an insulation layer together with the substrate. Thereafter, a through hole is formed by drilling a hole through the insulation layer and metal-plating it, and an outer layer circuit is formed by applying a subtractive method to the metal plated metal foil in one or both sides of the insulation layer, so as to manufacture a laminated wiring board.

### DISCLOSURE OF THE INVENTION

In general, a dicyandiamide-based curing system is most commonly used as a curing agent in manufacturing prepregs using a fire retardant brominated epoxy resin, but a phenolic compound-based curing system is used in the field requiring high reliability in low hygroscopicity and high heat resistance. The prepreg using the phenolic compound-based curing system has problems in quality such that cured products are rigid and brittle and have poor desmear capability.

In accordance with the present invention, it has been found that the quality problem of the desmear capability can be solved through making the cured product have an inflection point (i.e., glass transition temperature; hereinafter referred to as Tg) in the range of 120°C to 150°C, as measured with a differential scanning calorimeter (hereinafter referred to as DSC).

This invention, which has been attained in view of the above point, has a purpose to provide a prepreg having improved low hygroscopicity, heat resistance and desmear capability, and a copper-clad laminate board formed by hot molding of this prepreg.

### BRIEF DESCRIPTION OF THE INVENTION

In accordance with the invention according to claim 1, there is provided a prepreg for a printed wiring board, characterized in that a brominated epoxy resin is used, which provides a cured product of said brominated epoxy resin having an inflection point in the range of 120°C to 150°C, as measured by a differential scanning calorimeter; a peak intensity of infrared absorption spectrum at 2100 to 2300 cm⁻¹ of said brominated epoxy resin being 5% or less of a peak intensity around 1600 cm⁻¹ due to a benzene ring carbon-carbon double bond, as measured with an infrared absorption spectrometer.

In accordance with the invention according to claim 2, there is provided a prepreg for a printed wiring board, which prepreg is obtainable by impregnating a substrate with the above brominated epoxy resin, drying it and semi-curing it with a curing agent, characterized in that, as the curing agent, a phenol type curing agent is used having, within the molecule, on average two or more phenolic hydroxyl groups reactive with the epoxy resin.

In another aspect, an epoxy resin composition according to claim 2 is an epoxy resin composition containing, as essential components, a phosphorus compound having within the molecule on average at least 1.8 and less than 3 phenolic hydroxyl groups reactive with the epoxy resin and containing on average at least 0.8 phosphorus atoms, an inorganic filler having an average particle diameter of not larger than 30 µm, a bifunctional epoxy resin having average at least 1.8 and less than 2.6 epoxy groups, and a curing agent; characterized in that said bifunctional epoxy resin is contained in an amount of at least 51 % by weight based on the whole epoxy resin; a polyfunctional phenolic compound having on average at least 3 phenolic hydroxyl groups within the molecule is used as the curing agent; and the equivalent ratio (a/c) of the equivalent amount (a) of the phenolic hydroxyl groups in the phosphorous compound to the equivalent amount (c) of the epoxy groups in the bifunctional epoxy resin is at least 0.3 and less than 0.75.

In accordance with the invention according to claim 3, there is provided a prepreg for a printed wiring board, characterized in that a novolac resin containing a bifunctional component in an amount of 15% to 30% is used as the curing agent as described in claim 2.

In accordance with the invention according to claim 4, there is provided a prepreg for a printed wiring board, characterized in that a brominated epoxy resin having an epoxy equivalent of 300 to 500 g/eq is used as the brominated epoxy resin as described in claim 1, 2 or 3.

In accordance with the invention according to claim 5, there is provided a copper-clad laminate board, characterized in that the laminate board is obtained by hot molding of the prepreg for a printed wiring board as described in claim 1, 2, 3 or 4.

### DETAILED DISCLOSURE OF THE INVENTION

Embodiments of the present invention are described below.

Brominated epoxy resins used in this invention are not particularly restricted as far as the peak intensity at the wave number between 2100 cm⁻¹ and 2300 cm⁻¹ is 5% or less of the peak intensity of the benzene ring carbon-carbon double bond around 1600 cm⁻¹, as measured with the infrared absorption spectrophotometer, and the inflection point of the cured product of said brominated epoxy resin is between 120°C and 150°C, as measured by a differential scanning calorimeter. There may be mentioned epoxy resins, such as brominated bisphenol A type epoxy resins, brominated cresol novolac type epoxy resins, brominated bisphenol F type epoxy resins, brominated phenol novolac type epoxy resins and brominated dicyclopendadiene type epoxy resins; a peak intensity of the infrared absorption spectrum at wave numbers between 2100 cm⁻¹ and 2300 cm⁻¹ of these brominated epoxy resins being 5% or less of the peak intensity around 1600 cm⁻¹ due to the benzene ring carbon-carbon double bond, as measured with the infrared absorption spectrophotometer; these brominated epoxy resins providing a cured product having an inflection point between 120°C and 150°C, as measured with a differential scanning calorimeter; for example, brominated epoxy resins as given in the following examples. These resins may be used singly or as a mixture of two or more.

It is preferred that said brominated epoxy resin has an epoxy equivalent of 300 to 500 g/eq, in order to attain a cured product of said brominated epoxy resin having well-balanced Tg and desmear capability.

Besides the brominated epoxy resin, a non-brominated epoxy resin can be used as far as the effect of the present invention is not harmed. Suitable non-brominated epoxy resins include, for example, bisphenol A type epoxy resins, bisphenol F type epoxy resins, bisphenol S type epoxy resins, hydantoin type epoxy resins, alicyclic type epoxy resins, biphenyl type epoxy resins, cresol novolac type epoxy resins and dicyclopentadiene type epoxy resins. Two or more of these resins may be used in combination.

In addition, as the curing agent in this invention, there can be exemplified phenolic curing agents, such as phenol novolac, bisphenol A novolac, and cresol novolac, possessing two or more phenolic hydroxyl groups. Preferred as the curing agent is a novolac resin containing a bifunctional component in an amount of 15% to 30%, in order to improve moldability of copper-clad laminate boards. Moreover, it is preferred to use the curing agent in such an amount providing an equivalent ratio of the phenolic hydroxyl group to the epoxy group in the brominated epoxy resin in the range of 1.2:1 to 0.7:1, in order to achieve well-balanced properties, such as peel strength and Tg of the cured product of said brominated epoxy resin. Furthermore, cresol novolac and dicyandiamide can be mentioned as the curing agent used in the present invention.

Manufacture of the prepreg is described below.

To a resin as above are formulated a curing agent and a curing accelerator (for example, imidazole derivatives) in order to accelerate the curing reaction, followed by mixing them uniformly with a mixing machine or a blender to prepare a resin composition.

A substrate is impregnated with the resulting epoxy resin composition, followed by drying it to prepare a prepreg. A method of impregnating and drying the epoxy resin composition onto the substrate is not iparticularly limited, but, for example, after the substrate is immersed and impregnated with the epoxy resin varnish, the solvent is evaporated upon heating to semi-cure the epoxy resin composition to yield the prepreg.

As the base substrate, a glass cloth, an aramid cloth, a polyester cloth, a glass non-woven fabric, an aramid non-woven fabric, a polyester non-woven fabric, pulp paper and linter paper can be included. In addition, use of the glass cloth is preferred since a laminate board superior in flame retardancy can be obtained.

Preparation of the resin varnish in order to impregnate the substrate with the resin composition can be carried out using a solvent such as methyl ethyl ketone (MEK) or methoxypropanol (MP) for the epoxy resin composition.

The prepreg thus prepared has low hygroscopicity, high heat resistance, and good desmear capability as the quality of the molded product.

In order to manufacture a metal foil clad laminate board using the resulting prepreg, both a desired number of said prepreg sheets and a metal foil are stacked to form a compression substrate, which is hot-pressed to prepare a metal foil clad laminate board. As the metal foil, a copper foil or aluminum foil is used, and the thickness used is generally between 0.012 and 0.07 mm. Use of a copper foil is preferred because a laminate board with excellent electric properties can be obtained.

### Example

In the following, the present invention is specifically described in examples and comparative examples.

### Examples 1 to 10 and Comparative Examples 1 to 5

Examples 1 to 10 and Comparative Examples 1 to 5 were carried out using the following compounds in the proportion given in Table 1. All values are based on a ratio of the solid by weight.

As resin, brominated epoxy resins (Toto Chemical Co., "YDB-500", epoxy equivalent = 500g/eq; Dow Chemical Co., "DER530", epoxy equivalent = 430 g/eq; Dow Chemical Co., "DER539", epoxy equivalent = 450 g/eq; Chan Chun Synthetic Co., "BEB530", epoxy equivalent = 438 g/eq; Chan Chun Synthetic Co., "BET539", epoxy equivalent = 438 g/eq; Shell Chemical Co., "EPON-1123", epoxy equivalent = 432 g/eq; Vantico Co., "LZ8008", epoxy equivalent = 435 g/eq; WUXI DIC EPOXY Co., "Epiclon 1320", epoxy equivalent = 430 g/eq; and Dainippon Ink and Chemical Industries Ltd., "Epiclon 153", epoxy equivalent = 400 g/eq), a cresol novolac type epoxy resin (Dainippon Ink and Chemical Industries Ltd., "N-690", epoxy equivalent = 225/eq), a dicyclopentadiene type epoxy resin (Dainippon Ink and Chemical Industries Ltd., "HP-7200H", epoxy equivalent = 283 g/eq), and a trifunctional epoxy resin (Mitsui Chemical Co., "VF2802", epoxy equivalent = 380 g/eq) were used.

Furthermore, as curing agent, a bisphenol A type novolac (Dainippon Ink and Chemical Industry Ltd., "VH4170", bifunctional component = 25%, equivalent of the hydroxyl group = 118), cresol novolac (Dainippon Ink and Chemical Industries Ltd., "KA-163", bifunctional component = 5%, equivalent of the hydroxyl group = 118), and dicyandiamide (molecular weight = 84, equivalent of the theoretical active hydrogen = 21) were used.

As curing accelerator, imidazole (Shikoku Kasei Co., 2E4MZ.) was used.

As solvent, methyl ethyl ketone (MEK) and methylpropanol (MP) were used.

The resin varnish for impregnation of the substrate was prepared as follows.

Prescribed amounts of both epoxy resin and curing agent were weighed and added to MEK and MP. (The amount of MEK and MP was adjusted such that the solution formed became 70% by weight.) The mixture was stirred in Disper® for 2 hours.

As substrate, a glass cloth (Nitto Boseki Co., 7628 type cloth) was used. This glass cloth was impregnated at ambient temperature with a varnish of the resin composition prepared as mentioned above, followed by heating it by a non-contact type heater at approximately 130 to 170°C to evaporate the solvent in the varnish, dry and semi-cure the resin composition, yielding a prepreg.

The amount of the resin was adjusted to 100 parts by weight towards 100 parts by weight of the glass cloth.

An infrared absorption spectrum of the resin portion of the prepreg (340 mm x 510 mm) prepared as mentioned above was measured with a FT-infrared absorption spectrophotometer (JASCO Corp. FT/IR-350) to confirm whether the peak intensity at the wave numbers of 2100 to 2300 cm⁻¹ in the infrared spectrum is 5% or less of that of the benzene ring carbon-carbon double bond around 1600 cm⁻¹. The results are shown in Table 1.

Eight sheets of the prepreg (340 mm x 510 mm) prepared as mentioned above were stacked, to both sides of which a roughened surface of a copper foil (thickness 18 □m, GT foil, Furukawa Circuit Foil Co.) was faced and hot-pressed at 180°C and at 2.94 MPa for 90 minutes by laminate molding to yield a copper-clad laminate board. After preparation of the copper-clad laminate board, the copper foil was removed by etching and the cured resin was analyzed by using a DSC (Seiko Electronic Industries Ltd., DSC-220C). The results are given in Table 1.

In addition, physical properties of the prepreg obtained as described above were evaluated as follows. The results are shown in Table 1.

### (1) Moldability

A prepreg with different melt viscosity was prepared by the manufacturing method of the printed wiring board as described above and eight sheets of this prepreg (340 mm x 510 mm) were stacked, to both sides of which the roughened surface of the copper foil (thickness 18 □m,GT foil, Furukawa Circuit Foil Co.) was faced and hot-pressed at 180°C and at 2.94 MPa for 90 minutes by laminate molding to yield a copper-clad laminate board. After preparation of the copper-clad laminate board, the copper foil was removed by etching and presence of voids or smeared spots were inspected. The case where voids or smeared spots were not found was judged as "open circle, O", whereas the case where voids or smeared spots were found was judged as "cross, X".

In the case where neither voids nor smeared spots were found in a wide range of the melting viscosity in the copper foil, its moldability is excellent.

The melt viscosity was measured as follows.

A prepreg prepared as mentioned above was loosened by rubbing to a powder (passed through a 60 mesh filter in order to eliminate foreign materials such as glass fiber and others) and the powder was pelletized by a pellet press. The melt viscosity of these pellets was measured with a Koka type flow viscometer (Shimadzu Co., CTF-100). The measurement conditions are as follows: temperature of 130±0.2°C, nozzle with 0.5 Φ x 10 mm, load at 20 kg/cm², plunger area at 1.0 cm², and preheating time of 30 seconds.

### (2) Measurement of thermal decomposition temperature with TGA

Eight sheets of the prepreg (340 mm x 510 mm) prepared as mentioned above were stacked, to both sides of which a roughened surface of a copper foil (thickness 18 □m, GT foil, Furukawa Circuit Foil Co.) was faced, followed by hot-pressing them at 180°C under 2.94 MPa for 90 minutes through laminate molding to yield a copper-clad laminate board. After preparation of the copper-clad laminate board, the copper foil was removed by etching and the cured resin was analyzed by a thermal gravimetric analyzer, TGA (Shimadzu Co., TGA50/50H) to determine the temperature, at which the weight was decreased by 5%.

### (3) Water absorptivity

Eight sheets of the prepreg (340 mm x 510 mm) prepared as mentioned above were stacked, to both sides of which a roughened surface of a copper foil (thickness 18 □m, GT foil, Furukawa Circuit Foil Co.) was faced, followed by hot-pressing at 180°C under 2.94 MPa for 90 minutes through laminate molding to yield a copper-clad laminate board. After preparation of the copper-clad laminate board, the copper foil was removed by etching and the water absorptivity was evaluated by the following conditions.

Conditions for determination of the water absorptivity were the treatment with E-1/105 and pre-conditioning temperature, PCT (treatment at 121°C and under 100% humidity for 90 minutes).

### (4) Heat resistance

Eight sheets of the prepreg (340 mm x 510 mm) prepared as mentioned above were stacked, to both sides of which the roughened surface of the copper foil (thickness 18 □m,GT foil, Furukawa Circuit Foil Co.) was faced, followed by hot-pressing them at 180°C under 2.94 MPa for 90 minutes through laminate molding to yield a copper-clad laminate board. Heat resistance of these laminate boards was evaluated according to JIS-C6481 and the temperature generating blisters was referred to the heat resistance temperature in oven.

### (5) Generation of blisters

Eight sheets of the prepreg (340 mm x 510 mm) prepared as mentioned above were stacked, to both sides of which the roughened surface of the copper foil (thickness 18 □m, GT foil, Furukawa Circuit Foil Co.) was faced, followed by hot-pressing them at 180°C under 2.94 MPa for 90 minutes through laminate molding to yield a copper-clad laminate board. The generation of blisters in these laminate boards was evaluated according to IPC-TM-650 and the time required for generation of the blisters was referred to the T-288 time.

### (6) Desmear capability

Eight sheets of the prepreg (340 mm x 510 mm) prepared as mentioned above were stacked, to both sides of which the roughened surface of the copper foil (thickness 18 □m,GT foil, Furukawa Circuit Foil Co.) was faced, followed by hot-pressing them at 180°C under 2.94 MPa for 90 minutes through laminate molding to yield a copper-clad laminate board. After preparation of the copper-clad laminate board, the copper foil was removed by etching and cut into 10 cm square and the weight change before and after desmearing was referred to the desmear capability (mg/dm²).

The desmear capability was evaluated under the condition below.

Prior to desmearing, a specimen was air-dried at 120°C for 1 hour, and its initial weight was determined. Then, the specimen was subjected to a swelling process (MACuDiser® 9204) at 35°C for 3 minutes, a potassium permanganate process (MACuDiser® 9275) at 75°C for 7 minutes, and a neutralization process (MACuDiser® 9279) at 43°C for 5 minutes using a desmearing fluid from MacDermid Inc., air-dried at 120°C for 1 hour and weighed after these processes.

As is apparent from Table 1, it is possible, according to the present invention, to obtain prepregs for a printed wiring board superior in the hygroscopicity, heat resistance, and desmear capability as the printed wiring board material and the copper-clad laminate board use these prepregs.

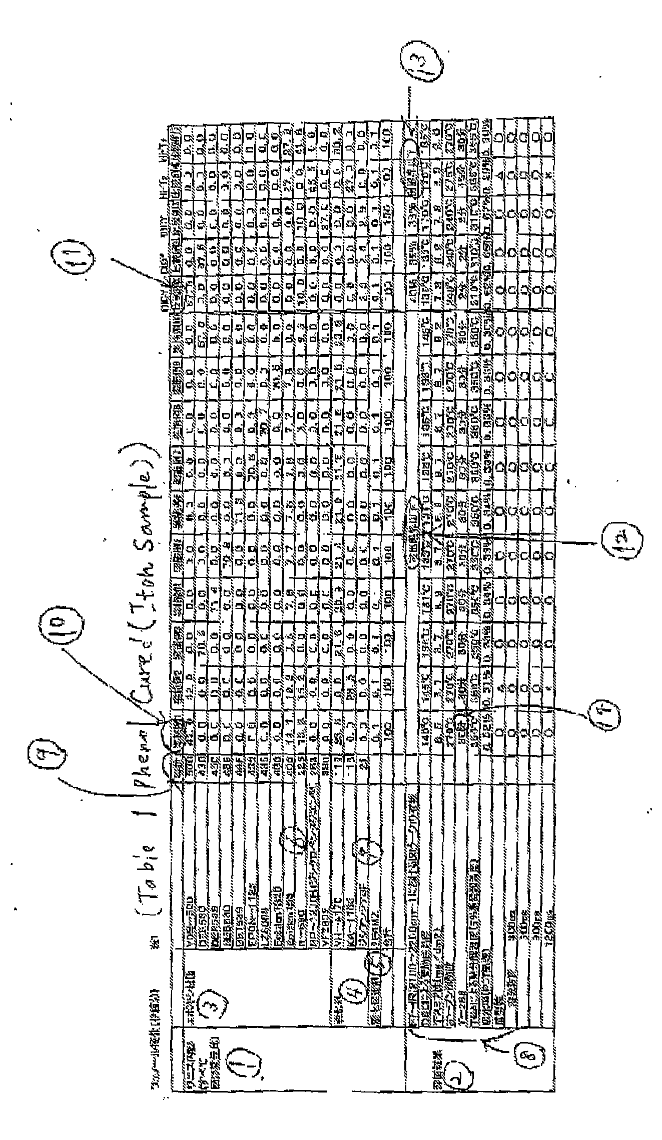

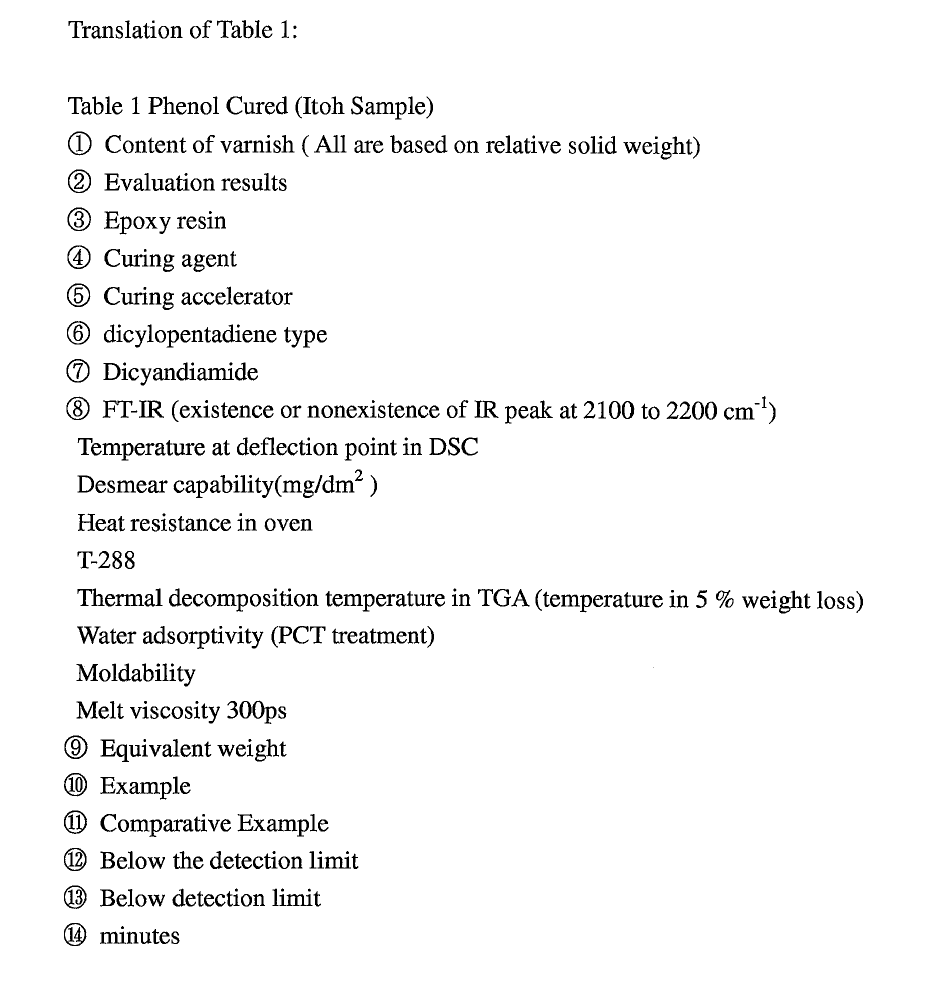

## Claims

1. A prepreg for a printed wiring board, **characterized in that** a brominated epoxy resin is used, which provides a cured product of said brominated epoxy resin having an inflection point in the range of 120°C to 150°C, as measured by a differential scanning calorimeter; a peak intensity of the infrared absorption spectrum at 2100 to 2300 cm⁻¹ of said brominated epoxy resin being 5% or less of a peak intensity around 1600 cm⁻¹ due to a benzene ring carbon-carbon double bond, as measured with an infrared absorption spectrometer.

2. A prepreg for a printed wiring board, which prepreg is obtainable by impregnating a substrate with the above brominated epoxy resin, drying it and semi-curing it with a curing agent, **characterized in that**, as the curing agent, a phenol type curing agent is used having, within the molecule, on average two or more phenolic hydroxyl groups reactive with an epoxy resin.

3. A prepreg for a printed wiring board, **characterized in that** a novolac resin containing a bifunctional component in an amount of 15% to 30% is used as the curing agent as described in claim 2.

4. A prepreg for a printed wiring board, **characterized in that** a brominated epoxy resin having an epoxy equivalent of 300 to 500 g/eq is used as the brominated epoxy resin as described in claim 1, 2 or 3.

5. A copper-clad laminate board, **characterized in that** the laminate board is obtainable by hot molding of the prepreg for a printed wiring board as described in claim 1, 2, 3 or 4.
